# EUROPÄISCHE PATENTSCHRIFT

(11) **EP 1 016 140 B1**
(45) Veröffentlichungstag und Bekanntmachung des Hinweises auf die Patenterteilung: **19.11.2003**
(21) Anmeldenummer: 98951273.6
(22) Anmeldetag: 04.09.1998
(51) Int. Cl.: H01L 23/58, H01L 23/552

(54) **VERDRAHTUNGSVERFAHREN FÜR HALBLEITER-BAUELEMENTE ZUR VERHINDERUNG VON PRODUKTPIRATERIE UND PRODUKTMANIPULATION, DURCH DAS VERFAHREN HERGESTELLTES HALBLEITER-BAUELEMENT UND VERWENDUNG DES HALBLEITER-BAUELEMENTS IN EINER CHIPKARTE**
METHOD FOR WIRING SEMI-CONDUCTOR COMPONENTS IN ORDER TO PREVENT PRODUCT PIRACY AND MANIPULATION, SEMI-CONDUCTOR COMPONENT MADE ACCORDING TO THIS METHOD AND USE OF SAID SEMI-CONDUCTOR COMPONENT IN A CHIP CARD
PROCEDE DE CABLAGE POUR COMPOSANTS A SEMI-CONDUCTEUR DESTINES A EMPECHER LE PIRATAGE ET LA MANIPULATION DES PRODUITS, COMPOSANT A SEMI-CONDUCTEUR PRODUIT SELON CE PROCEDE ET UTILISATION DU COMPOSANT A SEMI-CONDUCTEUR DANS UNE CARTE A PUCE

(30) Priorität: 19.09.1997 DE 19741507; 22.10.1997 DE 19746641
(43) Veröffentlichungstag der Anmeldung: 05.07.2000
(73) Patentinhaber: Fraunhofer-Gesellschaft zur Förderung der angewandten Forschung e.V., 80686 München (DE)
(72) Erfinder: RAMM, Peter, D-85276 Pfaffenhofen (DE); BUCHNER, Reinhold, D-85774 Unterföhring (DE)
(74) Vertreter: Gagel, Roland, Dr.
(86) Internationale Anmeldenummer: DE9802645
(87) Internationale Veröffentlichungsnummer: WO99016131

(56) Entgegenhaltungen:
- EP-A- 0 510 433
- EP-A- 0 582 850
- DE-A- 4 433 845
- US-A- 5 258 334
- NEUMEIER K ET AL: "Radiation tolerance of double layer field oxides" RADECS 91: FIRST EUROPEAN CONFERENCE ON RADIATION AND ITS EFFECTS ON DEVICES AND SYSTEMS (CAT. NO.91TH0400-2), LA GRANDE-MOTTE, FRANCE, 9-12 SEPT. 1991, Seiten 215-219, XP002093849 ISBN 0-7803-0208-7, 1992, New York, NY, USA, IEEE, USA in der Anmeldung erwähnt

## Beschreibung

Die vorliegende Erfindung betrifft ein Verfahren zur Herstellung eines mit einem oder mehreren leitenden Strukturelementen versehenen Halbleiter-Bauelements mit den Merkmalen des Oberbegriffs von Patentanspruch 1 sowie ein mit einem oder mehreren leitenden Strukturelementen versehenes Halbleiter-Bauelement, das durch solch ein Verfahren herstellbar ist. Insbesondere betrifft die vorliegende Erfindung ein Verfahren zur Herstellung einer metallisierten Halbleiter-Schaltungsstruktur, welches mit CMOS-kompatiblen Standard-Halbleiter-technologien durchführbar ist und die Anwendung des sogenannten Reverse Engineering zur Aneignung fremden Technologie-Knowhows bzw. zum Auslesen und/oder zur Manipula-tion der im Bauelement gespeicherten Information erschwert. Durch das erfindungsgemäße Verfahren ist es darüber hinaus möglich, ein gegenüber Umwelteinflüssen geschütztes Halbleiter-Bauelement herzustellen.

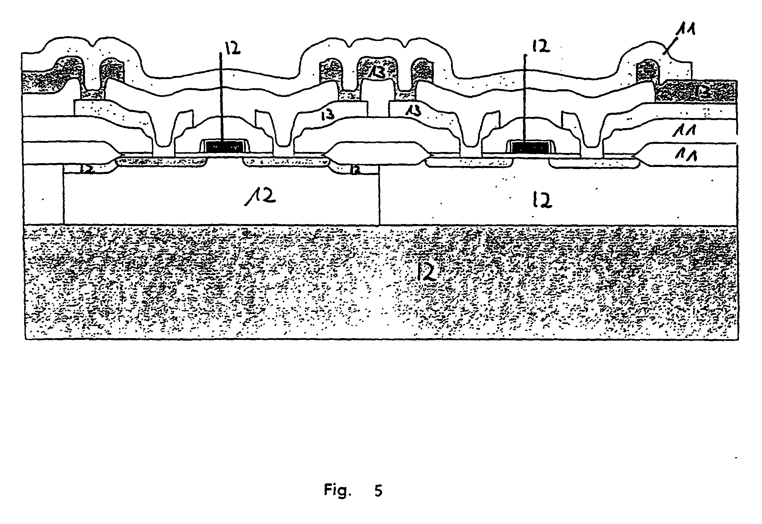

Ein Verfahren mit den Merkmalen des Oberbegriffs von Patentanspruch 1 ist beispielsweise aus G. Schumiki, P. Seegebrecht "Prozeßtechnologie", Springer-Verlag Berlin, ISBN 3-540-17670-5 bekannt. Fig. 5 zeigt ein durch solch ein Verfahren hergestelltes Halbleiter-Bauelement. In Fig. 5 bezeichnen die mit Bezugszeichen 11 bezeichneten Schichten Passivierungs- bzw. Isolatorschichten, die mit Bezugszeichen 12 bezeichneten Schichten stellen leitende Schichten dar, die beispielsweise aus dotiertem Halbleiter-Material oder aus dotierten Poly-Siliziumschichten aufgebaut sind, und die mit Bezugszeichen 13 bezeichneten Schichten stellen Metallisierungen dar. Die Verdrahtung 13 des Bauelementes wird mittels Deposition und Strukturierung von Metallschichten und dazwischenliegenden Isolatorschichten 11 realisiert. Bei diesem modularen Verfahren werden jeweils Kontaktlöcher durch eine Isolatorschicht 11 bis auf eine leitende Struktur 12, 13 geätzt, sodann eine Metallschicht abgeschieden und nachfolgend Leiterbahnen 13 strukturiert und wiederum mit einer lsolatorschicht 11 bedeckt.

Die mit solchen Halbleiter-Bauelementen verbundenen Probleme bestehen zum einen darin, daß mit Techniken des Reverse Engineering das Design und die Anordnung der Leiterbahnen innerhalb des Bauelements leicht erkannt werden kann und daß daher auch das Verfahren zur Herstellung eines solchen Halbleiter-Bauelements für Dritte leicht nachzuahmen ist.
Beispielsweise können Halbleiter-Bauelemente optisch durchstrahlt werden, und ihr Design kann mittels Elektronenstrahlmikroskopie entweder unter Verwendung von bildgebenden Verfahren oder aber auch unter Verfolgung eines fließenden Stroms leicht "durchschaut" werden. Desweiteren ist es auch üblich, Schicht für Schicht eines Halbleiter-Bauelements mechanisch oder chemisch abzutragen und anschließend die sich jeweils ergebende Oberfläche zu untersuchen.

Hält man sich die enormen Entwicklungskosten für neuartige Halbleiter-Chips vor Augen, so ist klar erkennbar, daß ein großer Bedarf an Möglichkeiten besteht, die Erfolgsaussichten solcher Reverse Engineering-Methoden entscheidend einzudämmen.

Ein weiteres Problem besteht darin, daß bei der Anwendung solcher Halbleiter-Bauelemente in Chipkarten Manipulationsmöglichkeiten für Dritte gegeben sind, die die Sicherheit von Chipkarten stark beeinträchtigen. Beispielsweise ist es durch spezielle Techniken möglich, die in den Chipkarten gespeicherte Information zu lesen und ggf. zu verändern.

Bisherige Ansätze zur Lösung der vorstehend genannten Probleme beruhten beispielsweise auf der Verbesserung der verwendeten PIN-Codes durch Verwendung einer Geheimzahl mit einer erhöhten Anzahl an Stellen, um den Mißbrauch von Chipkarten zu unterbinden.

Ansätze zur Lösung des mit den verwendeten Reverse Engineering-Methoden verbundenen Problems beruhten darauf, das Chipkarten-Design möglichst komplex zu gestalten, um die Erfolgsaussichten der vorstehend erwähnten optischen Durchstrahlungs- oder Elektronenmikroskopierverfahren zu verringern. Bei dem Versuch, eine aufzubauende Schaltung möglichst komplex zu gestalten, tritt jedoch wiederum das Problem auf, daß der Integrationsgrad der Schaltung deutlich verschlechtert werden kann und daß das Herstellungsverfahren technologisch aufwendig wird. Genauer gesagt läßt sich der Komplexitätsgrad insbesondere dadurch steigern, daß mehrere Metallisierungsebenen übereinander angeordnet werden. Aufgrund der Oberflächentopographie ist dafür aber auch eine Anpassung der jeweiligen Größen der Leiterbahnen notwendig, wodurch die Integrationsdichte der Metallisierung bei der entsprechenden Vorrichtung verschlechtert wird.
Aus der US-Patentschrift Nr. 5 563 084, die der DE-A-44 33 845 entspricht, ist überdies ein Verfahren zur Herstellung einer dreidimensionalen integrierten Schaltung bekannt. Bei diesem Verfahren werden bereits vollständig fertig prozessierte Chips unter Verwendung eines Handlingsubstrats auf ein weiteres Substrat, das seinerseits ebenfalls mehrere Bauelementelagen enthalten kann, aufgebracht. Um die Ausbeute zu erhöhen, wird die Funktionsfähigkeit der einzelnen Chips vor dem Zusammenfügen überprüft. Der vorliegenden Erfindung liegt somit die Aufgabe zugrunde, das bekannte Verfahren zur Herstellung eines mit einem oder mehreren leitenden Strukturelementen versehenen Halbleiter-Bauelements derart weiterzubilden, daß die Komplexität der Schaltung erhöht werden kann, ohne die Integrationsdichte zu verschlechtern und das Verfahren technologisch zu aufwendig zu gestalten. Ferner liegt der vorliegenden Erfindung die Aufgabe zugrunde, ein Halbleiter-Bauelement mit komplexerer Schaltung aber hoher Integrationsdichte bereitzustellen.
Gemäß der vorliegenden Erfindung wird die Aufgabe durch die kennzeichnenden Merkmale des Anspruchs 1 gelöst. Ferner wird gemäß der vorliegenden Erfindung ein Verfahren zur Herstellung eines mit einem oder mehreren leitenden Strukturelementen versehenen Halbleiter-Bauelements, das gegenüber Umwelteinflüssen geschützt ist, nach Anspruch 17, ein mit einem oder mehreren leitenden Strukturelementen versehenes Halbleiter-Bauelement nach Anspruch 19 sowie die Verwendung dieses Halbleiter-Bauelements in einer Chip-Karte bereitgestellt. Die bevorzugten Ausführungsformen sind Gegenstand der abhängigen Ansprüche.
Die vorliegende Erfindung betrifft somit ein Verfahren zur Herstellung eines mit einem oder mehreren leitenden Strukturelementen versehenen Halbleiter-Bauelements mit den Schritten zum
- Aufbringen und Strukturieren von Schichten, die in dem Halbleiter-Bauelement enthalten sind, auf einem ersten Substrat,
- Verbinden der Oberfläche des ersten Substrats, auf der diese einzelnen Schichten aufgebracht sind, mit einem zweiten Substrat,
- Bereitstellen des oder eines von den mehreren leitenden Strukturelementen auf der freien Oberfläche des ersten Substrats, wobei dieser Schritt so ausgeführt wird, daß ein funktionsmäßiger elektrischer Kontakt auf direktem Wege durch das erste Substrat hindurch zwischen dem leitenden Strukturelement und dem Bauelement bewirkt wird, und
- Fertigstellen des Halbleiter-Bauelements.
   Bei dem erfindungsgemäßen Verfahren wird die Bauelementelage im Substrat bis vor eine Metallisierungsebene prozessiert. Das heißt, der Ausgangspunkt ist jeweils eine Bauelementelage innerhalb eines Substrates ohne Metallisierung, mit einer oder mit mehreren Metallisierungsebenen.

Nachfolgend wird das nun vorliegende Bauelementesubstrat mit einem Handlingsubstrat Vorderseite zu Vorderseite zusammengefügt, und zusätzlich kann das Bauelementesubstrat von der Rückseite her gedünnt werden. Die darauffolgende Bereitstellung elektrischer Kontakte zum Bauelement, d.h. die Bereitstellung der auf die Bauelementelage innerhalb des Substrats ohne Metallisierung, mit einer oder mehreren Metallsierungsebenen folgenden Metallisierungsebene, erfolgt, indem Kontaktlöcher nach einem entsprechenden Lithographieschritt durch die ggf. gedünnte Bauelementesubstratschicht bis auf die zu kontaktierenden Gebiete geätzt und nachfolgend metallisiert werden.
Durch die Abfolge der Schritte des erfindungsgemäßen Verfahrens wird ein zusätzliches Substrat in das Bauelement eingebracht. Dieses Substrat kann entweder das Bauelementesubstrat selbst oder, bei einer iterativen Wiederholung der Verfahrensschritte gemäß Patentanspruch 12, dasjenige Handlingsubstrat sein, weiches in dem vorangehenden Iterationsschritt eingebracht wurde und entsprechend die Rolle des Bauelementesubstrats übernommen hat. Gemäß einer bevorzugten Ausführungsform kann dabei das zusätzliche Substrat beispielsweise zwischen dem Halbleiter-Bauelement an sich und der oder den zur elektrischen Kontaktierung des Halbleiter-Bauelements vorgesehenen Metallisierungsebenen angeordnet sein. Das zusätzliche Substrat kann aber auch zwischen einzelnen zur elektrischen Kontaktierung des Halbleiter-Bauelements vorgesehenen Metallisierungsebenen angeordnet sein. Der Ausdruck "Metallisierungsebenen" umfaßt dabei sämtliche leitende Strukturelemente des Halbleiter-Bauelements, also beispielsweise Leiterbahnen, Verdrahtungen usw.
Durch eine derartige Einbringung eines zusätzlichen Substrats ist es möglich, die Komplexität der sich ergebenden Schaltung beträchtlich zu erhöhen, ohne den Integrationsgrad der Vorrichtung zu verschlechtern oder das Herstellungsverfahren zu sehr kompliziert zu machen.
Bei dem erfindungsgemäßen Verfahren werden das Bauelementesubstrat und das Handlingsubstrat derart fest miteinander verbunden, daß daraufhin keine zerstörungsfreie Trennung des Schichtenstapels erfolgen kann.
Gemäß einer bevorzugten Ausführungsform ist das zusätzlich in das Bauelement eingebrachte Substrat aus einem Material, das im Bereich sichtbarer Wellenlängen nicht transparent ist, beispielsweise aus Silizium, so daß die Verwendung optischer Durchstrahlungsverfahren verhindert wird. Das zusätzliche Substrat kann zusätzlich noch ein Material enthalten oder aus einem solchen hergestellt sein, das im Bereich kurzwelliger Strahlung, beispielsweise Röntgenstrahlen, nicht transparent ist, so daß die Verwendung von Röntgen-Durchstrahlungsverfahren verhindert wird. Gemäß der vorliegenden Erfindung kann das zusätzliche Substrat auch ein sogenanntes SOI-Substrat sein, so daß die vergrabene lsolatorschicht bei einem Ätzschritt als ein Ätzstopp dient. Dadurch kann das Herstellungsverfahren weiter vereinfacht werden, und seine Kosten können reduziert werden. Ferner ist es bei Verwendung eines SOI-Substrats möglich, das zusätzliche Substrat gleichmäßiger zu ätzen.

Für die Verbindung der Vorderseite des Bauelementesubstrats mit dem Handlingsubstrat wird die Vorderseite des Bauelementesubstrats vorzugsweise mit einer Haftschicht versehen. Die Haftschicht kann dabei gleichzeitig eine passivierende und/oder planarisierende Funktion übernehmen. Anschließend wird das Bauelementesubstrat von der Rückseite her gedünnt. Das Dünnen kann dabei beispielsweise durch naßchemisches Ätzen oder durch mechanisches oder chemomechanisches Schleifen erfolgen. Der nach dem Zusammenfügen und Dünnen vorliegende Substratstapel kann darauf folgend wie ein Standardsubstrat weiterbearbeitet werden, wobei die Oberfläche des gedünnten Bauelementesubstrats nun die Vorderseite darstellt. Diese wird zunächst durch Abscheidung einer dielektrischen Schicht isoliert, wobei bei Verwendung eines SOI-Substrates unter Umständen auf diese Isolierung verzichtet werden kann. Nach einem Standardlithographieschritt werden durch die Isolatorschicht und die dünne Bauelementesubstratschicht Kontaktlöcher auf die zu kontaktierenden Gebiete geätzt und die Seitenwände der Kontaktlöcher isoliert. Über diese Kontakte wird schließlich die Verdrahtung mittels Standardmetallisierung, die aus einer oder mehreren Metallisierungsebenen bestehen kann, hergestellt. Die Kontakte können hierbei zwischen beliebigen Metallisierungsebenen des Bauelementesubstrats und der Verdrahtung realisiert werden. Schließlich kann, wie bei der Bauelementeherstellung gemäß dem Stand der Technik, die Substratscheibe auf die notwendige Dicke reduziert werden, indem der Substratstapel von der Handlingsubstratseite her mechanisch oder/und chemisch gedünnt wird.

Bei dem erfindungsgemäßen Verfahren wird gegenüber den nach dem heutigen Stand der Technik bekannten Verfahren zur Mehrlagenverdrahtung vorteilhafterweise den Möglichkeiten der Produktpiraterie und der Produktmanipulation begegnet, da Teile der Bauelementeverdrahtung auf die Seite des Bauelementesubstrats verlagert werden, die dem Bauelement an sich oder aber auch weiteren Teilen der Bauelementeverdrahtung gegenüberliegt. Bei den bekannten Verfahren zur Mehrlagenverdrahtung sind demgegenüber übereinander angeordnete strukturierte Metallschichten durch optisch transparente dielektrische Schichten, beispielsweise SiO₂, voneinander isoliert, wie in Fig. 5 gezeigt.

Durch Einbringen des zusätzlichen Substrats, das, wie vorstehend erläutert, das Bauelementesubstrat selbst oder auch ein Handlingsubstrat sein kann, kann die Komplexität der Verdrahtung erhöht werden, wodurch die üblicherweise eingesetzten Techniken zur Analytik des Schaltungsaufbaus und Techniken zur Manipulation der in den Bauelementen gespeicherten Information verhindert bzw. erschwert werden. Wenn das zusätzliche Substrat zusätzlich optisch nicht transparent ist, werden zum einen Verfahren zur optischen Durchleuchtung oder Analyse mittels Elektronenstrahlmikroskopie verhindert, zum anderen sind Verfahren zur Manipulation oder zum Auslesen der in der Schaltung bzw. der in der Chipkarte enthaltenen Information nicht mehr anwendbar.

Darüber hinaus kann das erfindungsgemäße Verfahren verwendet werden, um ein gegenüber Umwelteinflüssen geschütztes Halbleiter-Bauelement herzustellen. Insbesondere dient die erste Substratschicht, die ja nunmehr eine Zwischenschicht innerhalb des Halbleiter-Bauelements darstellt, als eine Schutzschicht gegenüber Umwelteinflüssen. Durch Auswahl eines geeigneten Materials für das erste Substrat kann diese Schutzfunktion erhöht werden.

Ferner können vor dem Schritt zum Bereitstellen des oder eines von den mehreren leitenden Strukturelementen noch weitere Schutzschichten aufgebracht werden, um die Schutzfunktion zu erhöhen. Beispiele für solche Schutzschichten können Passivierungsschichten, beispielsweise aus SiO₂ sein.

Insbesondere ist es bei einer iterativen Wiederholung der Verfahrensschritte, wenn also mehrere Substratschichten in das Bauelement eingebracht werden, möglich, das Halbleiter-Bauelement oder Teile davon einzukapseln, ggf. mit verschiedenen, geeignet ausgewählten Substrat- und/oder Zusatzschutzschichten.

Die vorliegende Erfindung wird im folgenden unter Bezugnahme auf die begleitenden Zeichnungen detaillierter beschrieben werden.

Fig. 1 zeigt ein Bauelementesubstrat mit fertig prozessierten MOS-Schaltungen und einer Metallisierungsebene vor der Verbindung mit einem Hilfssubstrat.

Fig. 2 zeigt das in Fig. 1 gezeigte Bauelementesubstrat nach Verbinden mit dem Hilfssubstrat und Dünnen des Bauelementesubstrats.

Fig. 3 zeigt den in Fig. 2 gezeigten Scheibenstapel, der wie eine Standardscheibe prozessiert wird.
Fig. 4 zeigt den in Fig. 3 gezeigten Scheibenstapel, der nun auf seiner Oberfläche mit einer Verdrahtungsebene versehen worden ist.
Fig. 5 zeigt einen typischen Schichtaufbau eines gemäß Standardverfahren hergestellten Halbleiterbauelementes mit mehreren leitenden Strukturelementen.

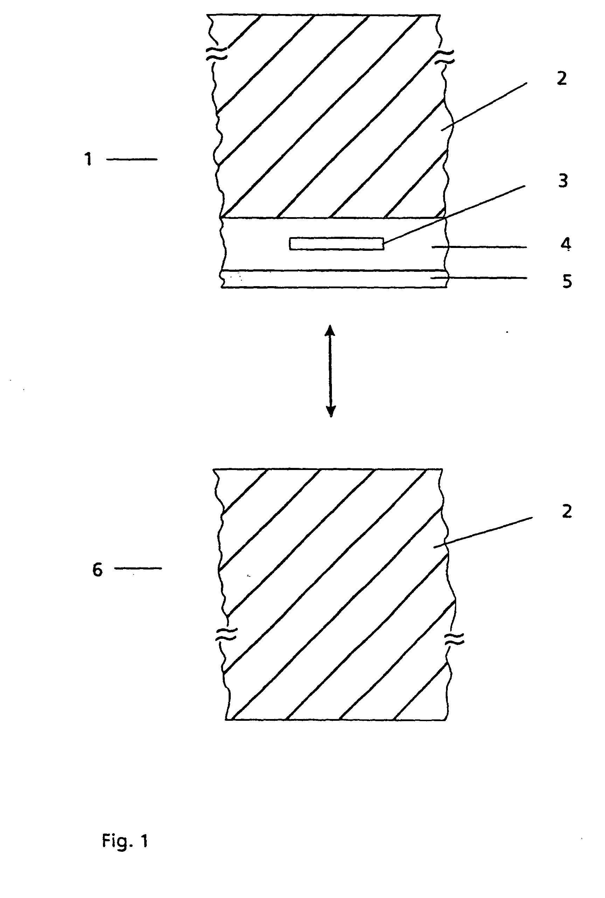

In Fig. 1 bezeichnet Bezugszeichen 1 ein Bauelementesubstrat, das beispielsweise eine Siliziumscheibe 2 mit fertig prozessierten MOS-Schaltungen und eine Metallisierungsebene 3 umfaßt. Die Metallisierungsebene 3 ist mit einer Oxidschutzschicht passiviert. Die Metallisierung umfaßt beispielsweise eine Aluminiumlegierung. Auf die Bauelementescheibe wird eine Polyimidschicht 5 als Haftschicht aufgeschleudert, so daß die Oberflächentopographie eingeebnet wird.
Die Einebnung der Oberflächentopographie kann auch bereits vor dem Aufbringen der Haftschicht durch einen Planarisierungsschritt erfolgt sein. Anschließend erfolgt das Verbinden der Bauelementescheibe mit einem Hilfssubstrat 6, beispielsweise einer weiteren Siliziumscheibe. Anschließend wird der nun vorliegende Scheibenstapel mechanisch, nachchemisch und/oder chemomechanisch von der Seite des Bauelementesubstrats her gedünnt, so daß die Siliziumrestdicke des Bauelementesubstrats einige Mikrometer beträgt.

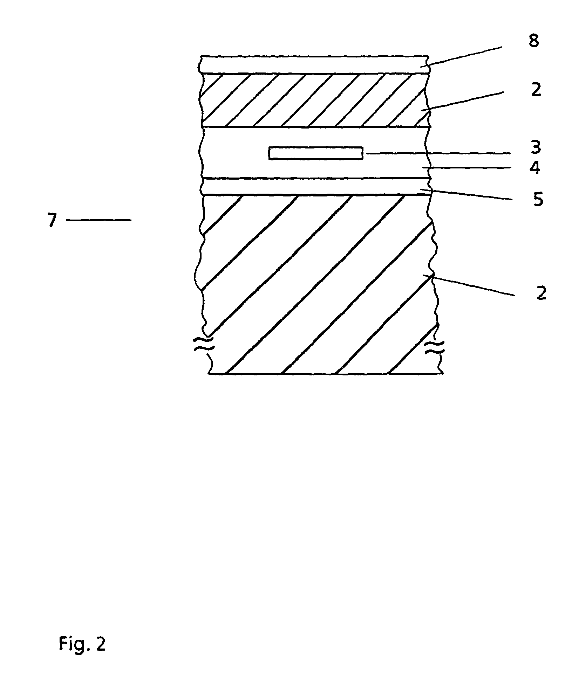

Nach dem Dünnen kann der Scheibenstapel 7, der beispielsweise in Fig. 2 gezeigt ist, wie eine Standardscheibe prozessiert werden.

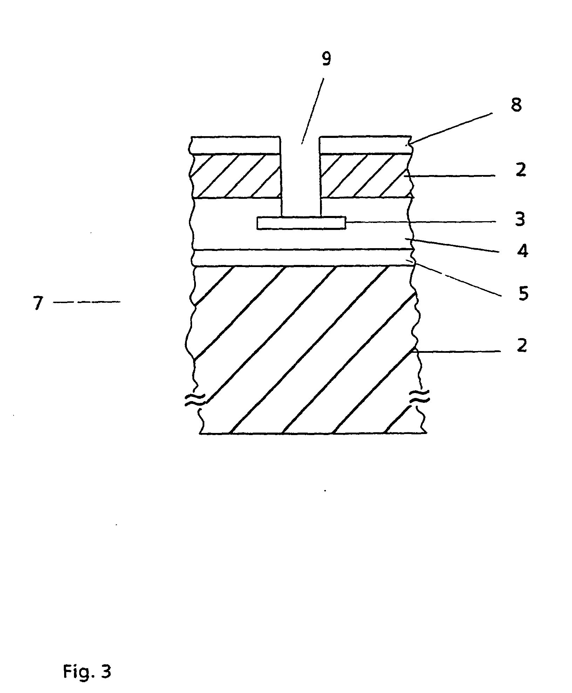

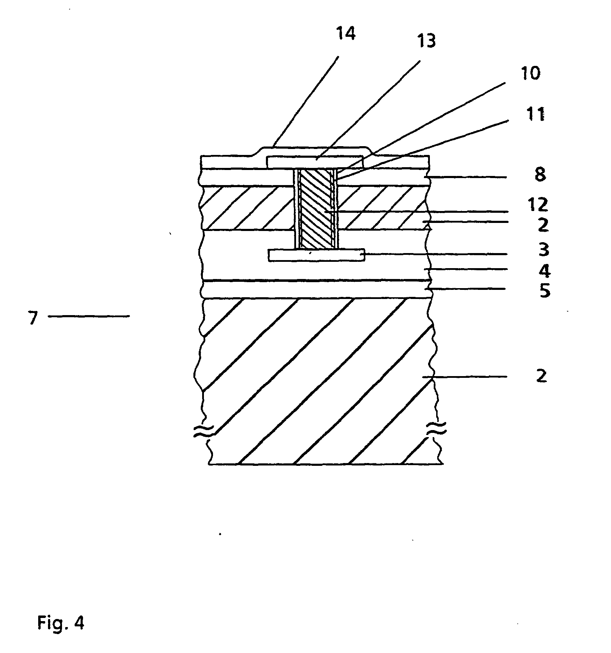

Beispielsweise wird die Siliziumoberfläche passiviert, z.B. mit einer Oxidschicht 8. Kontaktlöcher 9 werden nach einem entsprechenden Lithographieschritt bis auf die zu kontaktierenden Gebiete der Metallisierung geätzt, wie in Fig. 3 gezeigt ist. Anschließend werden, wie in Fig. 4 gezeigt, vorzugsweise die Seitenwände der Kontaktlöcher mit Isolierschichten 10 isoliert. Gemäß einer besonders bevorzugten Ausführungsform erfolgt dies durch eine sogenannte Spacer-Oxid-Prozeßsequenz, die eine konforme Oxidabscheidung und ein nachfolgendes anisotropes Rückätzen umfaßt.

Die Verdrahtung der Schaltungen erfolgt beispielsweise durch Abscheidung einer Titannitridschicht 11 als Haft- und Barriereschicht für die nachfolgende Wolframmetallisierung 12, die beispielsweise durch W-Deposition erfolgen kann. Anschließend wird unter Verwendung von chemomechanischem Schleifen mit einem CMP-Gerät die Wolfram/Titannitridschicht von der Substratoberfläche entfernt, so daß die verbleibenden Wolfram/Titannitrid-"Stöpsel" (sog. Plugs) die vertikale Verbindung zur Bauelementemetallisierungsebene realisieren. Schließlich wird durch einen Standardmetallisierungsprozeß, beispielsweise mit einer Aluminiumlegierung 13 und nachfolgende Passivierung 14 die Verdrahtung des Bauelements durchgeführt, wie in Fig. 4 gezeigt ist. Dabei kann die Verdrahtung des Bauelements auch mehrere Metallisierungsebenen umfassen. Es sind aber auch andere Verfahren zur Herstellung einer Verdrahtung der Schaltungen denkbar. Abschließend wird der Scheibenstapel von der Hilfssubstratseite her vorzugsweise mechanisch auf die notwendige Restdicke, z. B. 180 µm, gedünnt.
Es ist den Fachleuten offensichtlich, daß die vorliegende Erfindung wie vorstehend beschrieben in zahlreichen Ausführungsformen modifiziert werden kann.
Beispielsweise können das Hilfssubstrat 6 und/oder das Bauelementesubstrat 1 nach ggf. Dünnen des Bauelementesubstrats auf verschiedene Weisen prozessiert und/oder strukturiert werden. Insbesondere können virtuelle Leiterbahnen, die keinerlei Anschlüsse zu dem Bauelement aufweisen, in diesen Substraten hergestellt werden, um beim Reverse Engineering bewußt fehlerhafte Informationen zu liefern. Ebenso ist es möglich, die planarisierte Oberfläche des gemäß Fig. 4 prozessierten Bauelements mit einem weiteren Hilfssubstrat zu verbinden, um eine weitere Hilfssubstratschicht in das sich ergebende Bauelement einzubringen.

Auf diese Weise können beispielsweise bei einer Verdrahtung, die mehrere Verdrahtungsebenen umfaßt, diese jeweils durch ein zusätzlich hinzugefügtes Hilfssubstrat voneinander getrennt werden.

Das durch das erfindungsgemäße Verfahren hergestellte Halbleiter-Bauelement läßt sich besonders vorteilhaft in Chipkarten verwenden, da durch seinen speziellen Aufbau die Manipulationsmöglichkeiten von außen stark eingeschränkt sind. Insbesondere wird es Fälschern erschwert, beispielsweise mit Metallstiften durch die einzelnen Bauelementeschichten durchzudringen, um dadurch die in dem Chip gespeicherte Information auszulesen und/oder zu fälschen.

## Patentansprüche

1. Verfahren zur Herstellung eines mit einem oder mehreren leitenden Strukturelementen versehenen Halbleiter-Bauelements mit den Schritten zum
- Aufbringen und Strukturieren von Schichten (3, 4, 5), die in dem Halbleiter-Bauelement enthalten sind, auf einem ersten Substrat (1), **gekennzeichnet durch** die Schritte zum
- Verbinden der Oberfläche des ersten Substrats (1), auf der diese einzelnen Schichten aufgebracht sind, mit einem zweiten Substrat (6) derart fest, daß keine zerstörungsfreie Trennung beider Substrate erfolgen kann,
- Bereitstellen des oder eines von den mehreren leitenden Strukturelementen (12, 13) auf der freien Oberfläche des ersten Substrats, wobei dieser Schritt so ausgeführt wird, daß ein funktionsmäßiger elektrischer Kontakt auf direktem Wege **durch** das erste Substrat (1) hindurch zwischen dem leitenden Strukturelement (13) und den Schichten (3,4,5) bewirkt wird, und
- Fertigstellen des Halbleiter-Bauelements.

2. Verfahren nach Anspruch 1, **dadurch gekennzeichnet, daß** das erste Substrat (1 ) im Bereich sichtbarer Wellenlängen nicht transparent ist.

3. Verfahren nach Anspruch 1 oder 2, **dadurch gekennzeichnet, daß** das erste Substrat (1) ein Si-Substrat ist.

4. Verfahren nach Anspruch 1 oder 2, **dadurch gekennzeichnet, daß** das erste Substrat (1) ein SOI-Substrat ist.

5. Verfahren nach einem der Ansprüche 1 bis 4, **gekennzeichnet durch** den Schritt zum Dünnen des ersten Substrats (1) nach dem Schritt zum Verbinden der Oberfläche des ersten Substrats (1) mit dem zweiten Substrat (6).

6. Verfahren nach Anspruch 5, **dadurch gekennzeichnet, daß** das Dünnen durch Ätzen, mechanisches oder chemomechanisches Schleifen oder eine Kombination dieser Verfahren erfolgt.

7. Verfahren nach einem der Ansprüche 1 bis 6, **dadurch gekennzeichnet, daß** der Schritt zum Verbinden der Oberfläche des ersten Substrats (1) mit dem zweiten Substrat (6) den Schritt zum Aufbringen einer haftvermittelnden Schicht (5) umfaßt.

8. Verfahren nach Anspruch 7, **dadurch gekennzeichnet, daß** die haftvermittelnde Schicht (5) eine Polyimidschicht ist.

9. Verfahren nach einem der Ansprüche 1 bis 8, **dadurch gekennzeichnet, daß** der Schritt zum Verbinden der Oberfläche des ersten Substrats (1) mit dem zweiten Substrat (6) dergestalt ausgeführt wird, daß in dem sich ergebenden Halbleiter-Bauelement die erste Substratschicht (1 ) zwischen dem Halbleiter-Bauelement an sich und der oder den zur elektrischen Kontaktierung des Halbleiter-Bauelements vorgesehenen Metallisierungsebenen angeordnet ist.

10. Verfahren nach einem der Ansprüche 1 bis 8, **dadurch gekennzeichnet, daß** der Schritt zum Verbinden der Oberfläche des ersten Substrats (1) mit dem zweiten Substrat (6) dergestalt ausgeführt wird, daß in dem sich ergebenden Halbleiter-Bauelement die erste Substratschicht (1 ) zwischen einzelnen zur elektrischen Kontaktierung des Halbleiter-Bauelements vorgesehenen Metallisierungsebenen angeordnet ist.

11. Verfahren nach einem der Ansprüche 1 bis 8, **dadurch gekennzeichnet, daß** der Schritt zum Verbinden der Oberfläche des ersten Substrats (1) mit dem zweiten Substrat (6) dergestalt ausgeführt wird, daß in dem sich ergebenden Halbleiter-Bauelement die erste Substratschicht (1) zwischen den zur elektrischen Kontaktierung des Halbleiter-Bauelements vorgesehenen Metallisierungsebenen und einer zur elektrischen Kontaktierung der Metallisierungsebenen vorgesehenen Verdrahtung angeordnet ist.

12. Verfahren nach einem der Ansprüche 1 bis 8, **dadurch gekennzeichnet, daß** der Schritt zum Fertigstellen des Halbleiter-Bauelements einen oder mehrere Schritte zum
• Verbinden der Oberfläche der bereits fertiggestellten Schichtenfolge mit einem n-ten Substrat (n > 2), und
• Bereitstellen eines weiteren leitenden Strukturelements auf der freien Oberfläche des (n-1)-sten Substrats, wobei dieser Schritt so ausgeführt wird, daß ein funktionsmäßiger elektrischer Kontak auf direktem Wege durch das (n-1)-te Substrat hindurch zwischen dem leitenden Strukturelement und dem Bauelement bewirkt wird, umfaßt.

13. Verfahren nach einem der Ansprüche 1 bis 8 und 12, **gekennzeichnet durch** den Schritt zum Strukturieren des ersten oder (n-1)-ten Substrats vor dem Schritt zum Bereitstellen des oder eines von den mehreren leitenden Strukturelementen auf der freien Oberfläche des ersten oder (n-1)-ten Substrats.

14. Verfahren nach einem der Ansprüche 1 bis 8,12 und 13, **gekennzeichnet durch** den Schritt zum (teilweisen) Aufbringen einer zusätzlichen leitenden Schicht auf der freien Oberfläche des ersten oder (n-1)-ten Substrats.

15. Verfahren nach Anspruch 14, **gekennzeichnet durch** den Schritt zum Verbinden der mit der zusätzlichen leitenden Schicht versehenen Substratoberfläche mit einem weiteren Substrat.

16. Verfahren, nach einem der Ansprüche 1 bis 8,12 und 13, **gekennzeichnet durch** mehrere aufeinanderfolgende Schritte zum (teilweisen) Aufbringen einer zusätzlichen leitenden Schicht auf der freien Oberfläche des ersten oder (n-1)-ten Substrats und zum Verbinden der mit der zusätzlichen leitenden Schicht versehenen Substratoberfläche mit einem weiteren Substrat.

17. Verfahren nach einem der Ansprüche 1 bis 16 zur Herstellung eines mit einem oder mehreren leitenden Strukturelementen versehenen Halbleiter-Bauelements, das gegenüber Umwelteinflüssen geschützt ist.

18. Verfahren nach Anspruch 17, **gekennzeichnet durch** den Schritt zum Aufbringen einer oder mehrerer zusätzlicher Schutzschichten vor dem Schritt zum Bereitstellen des oder eines von den mehreren leitenden Strukturelementen auf der freien Oberfläche des ersten Substrats.

19. Mit einem oder mehreren leitenden Strukturelementen versehenes Halbleiter-Bauelement, herstellbar durch das Verfahren nach einem der Ansprüche 1 bis 18, zumindest bestehend aus einem ersten Substrat (1) mit einer ersten Oberfläche, auf der strukturierte Schichten (3, 4, 5) als Bauelementelage aufgebracht sind, und einem zweiten Substrat (6), das mit der ersten Oberfläche des ersten Substrates (1) derart fest verbunden ist, daß keine zerstörungsfreie Trennung beider Substrate erfolgen kann, wobei ein oder mehrere leitende Strukturelemente (12, 13) auf einer freien Oberfläche des ersten Substrats aufgebracht sind und ein funktionsmäßiger elektrischer Kontakt zwischen den leitenden Strukturelementen (13) und der Bauelementelage (3, 4, 5) auf direktem Wege durch das erste Substrat (1) hindurch hergestellt ist.

20. Verwendung des Halbleiter-Bauelements nach Anspruch 19 in einer Chip-Karte.

## Claims

1. A method for producing a semiconductor component provided with a conducting structural element or a plurality of conducting structural elements having the steps
- application and structuring of layers (3, 4, 5) contained in said semiconductor component on a first substrate (1),
**characterized by** the steps
- joining of the surface of said first substrate (1), on which said single layers are applied with a second substrate (6) in such a firm manner that nondestructive separation of said two substrates is impossible,
- provision of said or one of said plurality of conducting structural elements (12, 13)on the free surface of said first substrate, this step being executed in such a manner that an operating electrical contact is yielded directly through said first substrate (1) between said conducting structural element (13) and said layers (3, 4, 5), and
- completion of said semiconductor component.

2. A method according to claim 1,
wherein said first substrate (1) is not transparent in the visible wavelength range.

3. A method according to claim 1 or 2,
wherein said first substrate (1) is a Si substrate.

4. A method according to claim 1 or 2,
wherein said first substrate (1) is a SOI substrate.

5. A method according to one of the claims 1 to 4,
**characterized by** the step to thin said first substrate (1) after said step of joining the surface of said first substrate (1) with said second substrate (6).

6. A method according to claim 5,
wherein said thinning occurs by means of etching, mechanical or chemo-chemical polishing or a combination of said procedures.

7. A method according to one of the claims 1 to 6,
wherein said step of joining the surface of said first substrate (1) with said second substrate (6) comprises the step of applying a bond enhancing layer (5).

8. A method according to claim 7,
wherein said bond enhancing layer (5) is a polyimide.

9. A method according to one of the claims 1 to 8,
wherein said step of joining the surface of said first substrate (1) with said second substrate (6) is executed in such a manner that said first substrate layer (1) is disposed in the yielded semiconductor component between said semiconductor component itself and said metallization plane(s) provided for electrical contacting of said semiconductor component.

10. A method according to one of the claims 1 to 8,
wherein said step of joining the surface of said first substrate (1) with said second substrate (6) is executed in such a manner that said first substrate layer (1) is disposed in the yielded semiconductor component between single said metallization planes provided for electrical contacting of said semiconductor component.

11. A method according to one of the claims 1 to 8,
wherein said step of joining said first substrate (1) with said second substrate (6) is executed in such a manner that said first substrate layer (1) is disposed in the yielded semiconductor component between said metallization planes provided for electrical contacting of said semiconductor component and wiring provided for electrical contacting of said metallization planes.

12. A method according to one of the claims 1 to 8,
wherein said step of completion of said semiconductor comprises one or a plurality of steps
- joining of the surface of the already completed sequence of layers with a nth substrate (n>2), and
- provision of an additional conducting structural element on the free surface of the (n-1)st substrate, with said step being executed in such a manner that an operating electrical contact between said conducting structural element and said component is yielded directly through said (n-1)st substrate.

13. A method according to one of the claims 1 to 8 and 12,
**characterized by** a step of structuring said first or (n-1)st substrate before said step of provision of said conducting structural element or one of a plurality of said conducting structural elements on the free surface of said first or said (n-1)st substrate.

14. A method according to one of the claims 1 to 8, 12 and 13,
**characterized by** a step of (partial) application of an additional conducting layer on the free surface of said first or said (n-1)st substrate.

15. A method according to claim 14,
**characterized by** a step of joining said substrate surface provided with said additional conducting layer with a further substrate.

16. A method according to one of the claims 1 to 8, 12 and 13,
**characterized by** a plurality of successive steps of (partial) application of an additional conducting layer on the free surface of said first or said (n-1)st substrate and of joining said substrate surface provided with said additional conducting layer with a further substrate.

17. A method according to one of the claims 1 to 16 for producing a semiconductor component provided with a conducting structural element or a plurality of conducting structural elements which is protected against ambient influences.

18. A method according to claim 17,
**characterized by** a step for application of an additional protective layer or a plurality of additional protective layers before said step of provision of said conducting structural element or one of said plurality of conducting structural elements on the free surface of said first substrate.

19. A semiconductor component provided with one or a plurality of conducting structural elements, said semiconductor component being producible by means of the method according to one of the claims 1 to 18 and comprising at least one of said first substrate (1) having a first surface on which said structured layers (3, 4, 5) are applied as a component layer and a second substrate (6) which is joined to said first surface of said first substrate (1) so firmly that nondestructive separation of said two substrates is impossible, with
conductive structural element(s) (12, 13) being applied on a free surface of said first substrate and an operating electrical contact being produced between said conducting structural elements (13) and said component layer (3, 4, 5) directly through said first substrate.

20. Use of the semiconductor component according to claim 19 in a chip card.

## Revendications

1. Procédé pour fabriquer un composant semi-conducteur pourvu d'un ou de plusieurs éléments structurels conducteurs selon les étapes suivantes :
- application et structuration de couches (3, 4, 5) présentes dans le composant semi-conducteur, sur un premier substrat (1), **caractérisé par** les étapes suivantes :
- liaison tellement ferme de la surface supérieure du premier substrat (1) sur laquelle ces différentes couches sont appliquées, à un second substrat (6) qu'une séparation sans endommagement des deux substrats soit impossible,
- la mise à disposition du ou d'un des multiples éléments structurels (12, 13) conducteurs sur la surface supérieure libre du premier substrat ; cette étape étant réalisée de manière à créer directement un contact électrique fonctionnel à travers le premier substrat ( 1 ) entre l'élément structurel conducteur (13) et les couches (3, 4, 5), et
- réalisation du composant semi-conducteur.

2. Procédé selon la revendication 1, **caractérisé en ce que** le premier substrat (1) n'est pas transparent dans les zones de longueurs d'ondes visibles.

3. Procédé selon la revendication 1 ou 2, **caractérisé en ce que** le premier substrat (1) est un substrat Si.

4. Procédé selon la revendication 1 ou 2, **caractérisé en ce que** le premier substrat (1) est un substrat SOI.

5. Procédé selon une des revendications 1 à 4, **caractérisé par** l'étape où on rend mince le premier substrat (1) après l'étape de liaison de la surface supérieure du premier substrat (1) avec le second substrat (6).

6. Procédé selon la revendication 5, **caractérisé en ce que** l'on rend mince par décapage, un ponçage mécanique ou chimico-mécanique ou une combinaison de ces procédés.

7. Procédé selon une des revendications 1 à 6, **caractérisé en ce que** l'étape pour lier la surface supérieure du premier substrat (1) avec le second substrat (6), comprend l'étape d'application d'une couche (5) transmettant l'adhésion.

8. Procédé selon la revendication 7, **caractérisé en ce que** la couche (5) transmettant l'adhésion est une couche polyamide.

9. Procédé selon une des revendications 1 à 8, **caractérisé en ce que** l'étape pour lier la surface supérieure du premier substrat (1) au second substrat (6) est réalisée de manière à ce que la première couche de substrat (1) soit disposée dans le composant semi-conducteur entre le composant semi-conducteur lui-même et les plans de métallisation prévus pour le contact électrique du composant semi-conducteur.

10. Procédé selon une des revendications 1 à 8, **caractérisé en ce que** l'étape pour relier la surface supérieure du premier substrat (1) avec le second substrat (6) est réalisée de manière à ce que la première couche de substrat (1) soit disposée dans le composant semi-conducteur entre différents plans de métallisation prévus pour le contact électrique du semi-conducteur.

11. Procédé selon une des revendications 1 à 8, **caractérisé en ce que** l'étape pour relier la surface supérieure du premier substrat (1) avec le second substrat (6) est réalisé de manière à ce que la première couche de substrat (1) soit disposée dans le composant semi-conducteur entre les plans de métallisation prévus pour le contact électrique du composant semi-conducteur et un câblage prévu pour le contact électrique des plans de métallisation.

12. Procédé selon une des revendications 1 à 8, **caractérisé en ce que** l'étape pour réaliser le composant semi-conducteur comprend une ou plusieurs étapes pour :
- relier la surface supérieure de la succession de couches mises à disposition avec un n^{ième} substrat (n > 2) ,et
- la mise à disposition d'un élément structurel conducteur supplémentaire sur la surface supérieure libre du substrat (n-1); cette étape étant réalisée de manière à ce qu'un contact électrique fonctionnel soit créée de façon directe à travers le substrat (n-1) entre l'élément structurel conducteur et le composant.

13. Procédé selon une des revendications 1 à 8 et 12, **caractérisé par** l'étape pour structurer le premier ou le (n-1)^{ième} substrat avant l'étape de mise à disposition du ou d'un des multiples éléments structurels sur la surface supérieure libre du premier ou du (n-1) substrat.

14. Procédé selon une des revendications 1 à 8, 12 et 13, **caractérisé par** l'étape pour appliquer (en partie) une couche conductrice supplémentaire sur la surface supérieure libre du premier ou (n-1)^{ième} substrat.

15. Procédé selon la revendication 14, **caractérisé par** l'étape de liaison de la surface supérieure de substrat pourvue d'une couche conductrice supplémentaire avec un autre substrat.

16. Procédé selon une des revendications 1 à 8, 12 et 13, **caractérisé par** plusieurs étapes se suivant destinées à appliquer (en partie) une couche conductrice supplémentaire sur la surface supérieure libre du premier ou (n-1)^{ième} substrat et pour relier la surface supérieure du substrat pourvue d'une couche conductrice supplémentaire avec un autre substrat.

17. Procédé selon une des revendications 1 à 16 pour fabriquer un composant semi-conducteur pourvu d'un ou de plusieurs éléments structurels conducteurs, lequel est protégé des influences de l'environnement.

18. Procédé selon la revendication 17, **caractérisé par** l'étape d'application d'une ou de plusieurs couches de protection supplémentaires avant l'étape de mise à disposition du ou d'un des multiples éléments structurels conducteurs sur la surface supérieure libre du premier substrat.

19. Avec un ou plusieurs composant semi-conducteur pourvu de multiples éléments structurels conducteurs, susceptibles d'être fabriqués par le procédé selon une des revendications 1 à 18, composé au moins d'un premier substrat (1) avec une première surface supérieure sur laquelle des couches (3, 4, 5) structurées sont appliquées en tant que couches de composants, et d'un second substrat (6) qui est relié avec la première surface supérieure du premier substrat ( 1) de manière tellement ferme qu'aucune séparation sans endommagement des deux substrats n'intervienne ; un ou plusieurs éléments structurels (12, 13) conducteurs se trouvant appliqués sur une surface supérieure libre du premier substrat et un contact électrique fonctionnel entre les éléments structurels (13) conducteurs et la couche des composants (3, 4, 5) étant ainsi créée.

20. Utilisation du composant semi-conducteur selon la revendication 19 dans une carte à puce.
